# EUROPEAN PATENT APPLICATION

(11) **EP 3 297 039 A1**
(43) Date of publication of application: **21.03.2018**
(21) Application number: 16799034.0
(22) Date of filing: 04.02.2016
(51) Int. Cl.: H01L 31/042, H01L 31/0224, H01L 31/05, H01L 31/18

(54) **SOLAR CELL PIECE, SOLAR CELL MODULE, CELL PIECE UNIT, AND PREPARATION METHOD THEREFOR**

(30) Priority: 22.05.2015 CN 201510267213; 31.12.2015 CN 201511027962
(71) Applicant: Suzhou Autoway System Co., Ltd., Suzhou, Jiangsu 215021 (CN)
(72) Inventor: LU, Qiankun, Suzhou, Jiangsu 215021 (CN)
(74) Representative: Rössler, Matthias
(86) International application number: PCT/CN2016/073451
(87) International publication number: WO 2016/188145

(57) **Abstract**

A solar cell piece, a solar cell module, a cell piece unit, and a preparation method therefor; the solar cell piece comprises an aluminum back field coating, a silicon chip layer, and thin gate lines; a front surface of the solar cell piece is partitioned into at least two independent areas, at least one front main gate line being disposed at an edge of one side of each area or a position close to the edge, all the thin gate lines being disposed at an edge of one side of each area or a position close to the edge, all the thin gate lines on the front surface of this area being electrically connected to the front main gate lines of this area; the solar cell piece no longer needs a plurality of traditional front longitudinal main gate lines, and may no longer need a soldering strip connecting process, thus reducing the coverage area of main gate lines, reducing the production cost and improving the efficiency of a solar cell module.

## Description

### TECHNICAL FIELD OF THE INVENTION

The present invention relates to a solar cell piece and a preparation method therefor, and more particularly, to a solar cell piece used for preparing a solar cell photovoltaic module and a preparation method therefor.

### BACKGROUND OF THE INVENTION

In recent years, the photovoltaic industry has seen rapid growth and development due to the wide application use of solar energy. In traditional solar cell module manufacturing process, due to the structural characteristics of the solar cell piece, a plurality of solar cell pieces and solder strips must be first soldered and series-connected together to form into a solar cell string. Subsequently, the solar cell strings and other components are assembled into one solar cell module unit.

Due to the presence of solder strips on the aforesaid traditional solar cell piece, the light-receiving area of the aforesaid traditional solar cell piece is sharply decreased, which in turn greatly reduces the effective power-generating area of the solar cell piece. Furthermore, the cell pieces are spaced apart from each other when formed into a series-connected cell string, which also greatly decreases the light-receiving area or the power-generating area. These two factors cause low power generation efficiency of the traditional solar cell pieces

### SUMMARY OF THE INVENTION

The purpose of the present invention is to solve the shortcomings of the prior art, by providing a solar cell piece that has a larger light-receiving area, a higher output power and a higher power-generating efficiency, and a method of preparation is provided therefor.

To achieve the above purpose, the present invention adopts the following technical solution:
A solar cell piece comprising an aluminum back field coating, a silicon chip layer and thin gate lines; a front surface of the solar cell piece is partitioned into at least two independent areas, at least one front main gate line being disposed at an edge of one side of each area or a position close to the edge, all the thin gate lines on the front surface of this area being electrically connected to the front main gate lines of this area.

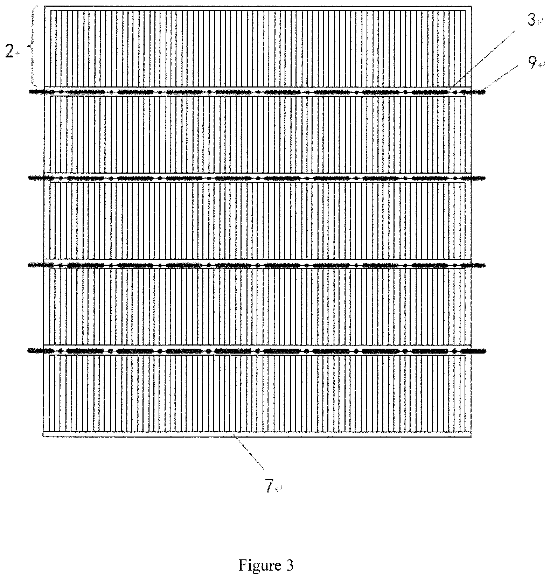

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and electrically connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are laterally arranged, thereby partitioning the solar cell piece into at least two independent areas. Each area is provided with one front main gate line, and each main gate line will only collect the current of the energy conversion units in its own area (located on one side of the front main gate line). In order to improve the energy conversion efficiency, such an area is preferred to be as small as possible, so that the path from the thin gate lines to the main gate line is shorter, thus improving the collection and conversion efficiency. Being limited by the production process and cost, the quantity of the independent area is preferred to be between two to six. According to the actual requirement, a solar cell piece can be provided with more than seven independent areas. In the process of preparing a solar cell module, the solar cell piece of the present invention has a higher flexibility. For instance, (1) each area can be cut into a plurality of independent solar cell piece units. The solar cell piece units can then be electrically connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area. (2), When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (as shown in Figure 3) can be achieved. Thus, the circuit structure of the solar cell module can have more combinations. (3), The above two connection methods can be freely combined to form various circuit structures of the solar cell module. (4), The front main gate line in one area can be connected to the back electrodes in another area by means of the connecting wires. Thus, all areas of the solar cell piece can be first series-connected, parallel-connected or series-parallel connected without being cut. Subsequently, a plurality of solar cell pieces is connected in series, thereby completing the assembly of a solar cell module.

In another aspect of the present invention, the back surface of the solar cell piece corresponds to the front surface area. A back main gate line is disposed at an edge of one side or a position close to the edge which is opposite to the main gate line that is disposed in the corresponding area of the front surface of the solar cell piece. The back main gate line is electrically connected to the back electrodes in the corresponding area of the solar cell piece.

In another aspect of the present invention, an isolation zone, which enables the adjacent areas to be electrically isolated, is provided between adjacent areas on the front surface of the solar cell piece.

In another aspect of the present invention, a portion of the back surface of the solar cell piece, which corresponds to the positon of the isolation zone of the front surface, is not provided with the aluminum back field coating.

In another aspect of the present invention, a portion of the back surface of the solar cell piece, which corresponds to the position between the front surface areas, is provided with line-shaped or strip-like separating lines having no aluminum back field coating.

In another aspect of the present invention, the front main gate lines of the two outermost areas on the front surface of the solar cell piece are disposed at an edge or a position close to the edge of the outermost portion of the solar cell piece.

In another aspect of the present invention, the two ends of the front main gate line, which exist along the direction of the main gate line, are disposed close to the edge of the outermost portion of the solar cell piece.

In another aspect of the present invention, the front main gate line is a single through-line.

In another aspect of the present invention, the front main gate line is composed of at least two separated soldering portion gate lines and at least one connecting portion gate line. The width of the soldering portion gate line is greater than that of the connecting portion gate line. The soldering portions are connected through the connecting portions.

In another aspect of the present invention, transverse thin gate lines, which connect the adjacent thin gate lines, and are perpendicular to the thin gate lines, are disposed between the thin gate lines.

A method for preparing the electrodes of a solar cell piece, comprising the steps of:
Step 1: printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel, and the main gate lines of the two edge areas of the solar cell piece being respectively disposed at the edge or close to the edge of the solar cell piece;
Step 2: printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.

The present invention further provides a solar cell module, which comprises at least two cell piece units that are electrically bonded together. The cell piece unit comprises a front surface and a back surface. The front surface of the cell piece unit is provided with a power-generating area and a front main gate line that is disposed at an edge of one side of the power-generating area. The power-generating area is provided with a plurality of thin gate lines, and the thin gate lines are connected to the front main gate line. The back surface of the cell piece unit is provided with a back main gate line and an aluminum back surface field. The front main gate line and the back main front line are respectively disposed on two opposite sides of the cell piece unit, wherein the back main gate line of one cell piece unit is bonded to and electrically connected to the front main gate line of another cell piece unit. The cell piece units are formed by cutting the solar cell piece into independent areas.

In another aspect of the present invention, the front main gate line is connected to one end of the thin gate line.

A method for preparing the aforesaid cell piece unit, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, an edge of one side of the front screen-printed pattern being provided with the front edge main gate line;
   The back screen-printed pattern comprises back main gate lines and an aluminum back surface field; the back main gate lines and the front main gate line are disposed in the same direction; an edge of one side of the back screen-printed pattern is provided with the back edge main gate line; the front edge main gate lines and the back edge main gate lines are respectively disposed on two opposite sides of the silicon chip layer;
Step 2: cutting: cutting the silicon chip layer through a cutting apparatus along a cutting line, thereby forming a plurality of the cell piece units, wherein the cutting line is used to cut the silicon chip layer into independent cell piece units;
Step 3: bonding: applying an electrically conductive bonding material on the front main gate line of the first cell piece unit, and bonding the back main gate line of the second cell piece unit to the front main gate line of the first cell piece unit, thereby allowing the two cell piece units to be bonded together; subsequently, bonding the third cell piece unit to the second cell piece unit in the same way; repeating the above step until all the cell piece units are electrically bonded together, thereby completing the preparation of the solar cell piece.
   In another aspect of the present invention, the electrical conductive bonding material used in step 3 can be an electrical conductive adhesive, a soldering paste, an electrical conductive tape, or a solder strip.

### BRIEF DESCRIPTION OF THE DRAWINGS

To clearly expound the technical solution of the present invention, the drawings and embodiments are hereinafter combined to illustrate the present invention. Obviously, the drawings are merely some embodiments of the present invention and those skilled in the art can associate themselves with other drawings without paying creative labor.
Figure 1 is a structural diagram illustrating the front screen-printed pattern of the solar cell piece of the present invention;
Figure 2 is a structural diagram illustrating the back screen-printed pattern of the solar cell piece of the present invention;
Figure 3 is a schematic diagram illustrating the cutting process of the solar cell piece of the present invention;
Figure 4 is a structural diagram illustrating the front surface of the cell piece unit of the solar cell piece of the present invention;
Figure 5 is a structural diagram illustrating the back surface of the cell piece unit of the solar cell piece of the present invention;
Figure 6 is a schematic diagram illustrating the bonding process of the solar cell piece of the present invention;
Figure 7 is another schematic diagram illustrating the bonding process of the solar cell piece of the present invention;
Figure 8 is a schematic diagram illustrating the finished product formed by two cell piece units being bonded together in a process of preparing a solar cell piece of the present invention;
Figure 9 is a structural diagram of the solar cell piece of the present invention;
Figure 10 is a structural diagram of the solar cell module;
Figure 11 is another structural diagram of the solar cell module; and
Figure 12 is a structural diagram of the front main gate line of the solar cell piece.

### Marking Instructions of the Drawings:

1, Cell Piece Unit , 2, Power-generating Area , 3, Front Main Gate Line , 4, Thin Gate Line , 5, Back Main Gate Line , 6, Aluminum Back Surface Field, 7, Front Edge Main Gate Line , 8, Back Edge Main Gate Line , 9, Cutting Line , 10, Conductive Bonding Material , 31, Soldering Portion Gate Line , 32, Connecting Portion Gate Line.

### DETAILED DESCRIPTION OF THE INVENTION

The embodiments described in the present invention will now be described with reference to the accompanying drawings of the present invention, and it will be apparent that the described embodiments are merely part of the examples of the invention and are not intended to be exhaustive. All other embodiments obtained by those of ordinary skill in the art without making creative work are within the scope of the present invention, based on embodiments in the present invention.

Drawings and detailed embodiments are combined hereinafter to elaborate the technical principles of the present invention.

The present invention provides a solar cell piece, comprising an aluminum back field coating, a silicon layer and thin gate lines, with below features; the front surface of the solar cell piece is partitioned into at least two independent areas; for each independent areas, at least one front main gate line being disposed at the edge of one side of each area or a position close to the edge; all the thin gate lines on the front surface of this area are electrically connected to the front main gate lines of this area.

The aforesaid solar cell piece is an essential component for preparing a solar cell module. In a traditional process, the solar cell piece comprises a silicon chip layer, an aluminum back field coating, front thin gate lines, and three or four longitudinal main gate lines. When preparing a solar cell module, the main gate lines of a plurality of solar cell pieces need to be soldered and connected in series by means of solder strips. Meanwhile, all energy conversion units of a traditional solar cell piece are usually connected into an integral body through the thin gate lines and the main gate lines. Each main gate line simultaneously collects the current of the energy conversion units on the left and right sides. The main gate lines of the solar cell piece of the present invention are laterally arranged, thereby partitioning the solar cell piece into at least two independent areas. Each area is provided with one front main gate line, and each main gate line will only collect the current of the energy conversion units in its own area (located on one side of the front main gate line).In order to improve the energy conversion efficiency, such an area is preferred to be as small as possible, so that, the path from the thin gate lines to the main gate line is shorter, thus improving the collection and conversion efficiency. Being limited by the production process and cost, the quantity of the independent area is preferred to be between two to six. According to the actual requirement, a solar cell piece can be provided with more than seven independent areas. In the process of preparing a solar cell module, the solar cell piece of the present invention has a higher flexibility. For instance, (1) each area can be cut into a plurality of independent solar cell piece units. The solar cell piece units can then be connected in series, and the two ends of the solar cell piece units can be series-connected in a staggered and shingled overlapping manner. When the main gate line of each solar cell piece unit is disposed at the top of each solar cell piece unit, the upper edge of each lower cell piece unit is exactly overlapped with the lower edge of each upper cell piece unit as these cell piece units are arranged from top to bottom and the main gate line of each lower cell piece unit is exactly covered by the lower edge of each upper cell piece unit, enabling the main gate lines of each lower cell piece unit to be connected to the back positive electrode of each upper cell piece unit. In this way, all the cell piece units are series-connected by repeating the above step. Thus, the main gate lines will no longer appear on the front surface of the solar cell module and this eliminates the spaces occupied by the main gate lines. In such a configuration, the effective power-generating area of the whole solar cell module is significantly increased. Meanwhile, it's unnecessary to connect the solar cell pieces via the solder strips, thereby solving problems such as complicated process, high production cost and wastage of effective power-generating area. (2) When the cell piece units are arranged in a staggered and shingled overlapped manner, and the front main gate line of a next cell piece unit is insulated from the back positive electrodes of a previous cell piece unit, the front main gate lines of all the cell piece units are connected on the side surface or on the back surface, and the back positive electrodes of all the cell piece units are connected together. After extracting the back positive electrodes, a solar cell module having a parallel structure (as shown in Figure 3) can be achieved. Thus, the circuit structure of the solar cell module can have more combinations. (3) The above two connection methods can be freely combined to form various circuit structures of the solar cell module. (4) The front main gate line in one area can be connected to the back electrodes in another area by means of the connecting wires. Thus, all areas of the solar cell piece can be first series-connected, parallel-connected or series-parallel connected without being cut. Subsequently, a plurality of solar cell pieces are connected in series, thereby completing the assembly of a solar cell module.

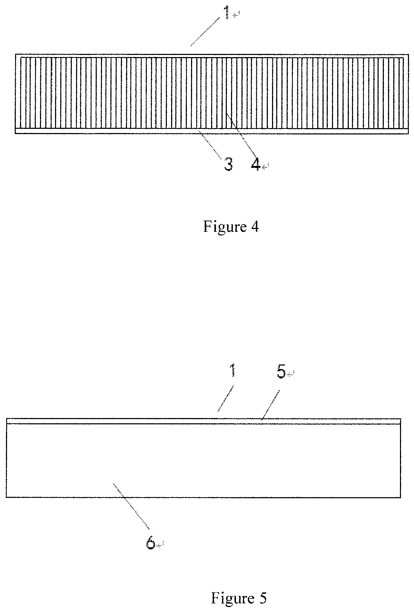

As shown in Figures 4, 5 and 9, in some embodiments of the solar cell piece of the present invention, the solar cell piece is cut into a plurality of independent cell piece units by areas. In specific applications, each solar cell module comprises at least two cell piece units 1 that are electrically bonded together. The cell piece unit 1 comprises a front surface and a back surface. The front surface of the cell piece unit is provided with a power-generating area 2 and a front main gate line 3 that is disposed at an edge of one side of the power-generating area 2. The power-generating area 2 is provided with a plurality of thin gate lines 4, and the thin gate lines 4 are connected to the front main gate line 3. The back surface of the cell piece unit is provided with a back main gate line 5 and an aluminum back surface field 6. The front main gate line 3 and the back main front line 5 are respectively disposed on two opposite sides of the cell piece unit 1, wherein the back main gate line 5 of one cell piece unit 1 is bonded to and electrically connected to the front main gate line 3 of another cell piece unit. Specifically, when two cell piece units 1 are bonded, the front main gate line 3 of one cell piece unit is only bonded to the back main gate line 5 of the other cell piece unit. In this example, the quantity of the cell piece unit is five. The number of cell piece unit can be three or more, and is not restricted herein.

After adopting the above technical solution, the present invention has the following advantages: since the solar cell piece is formed by electrically bonding a plurality of cell piece units 1, the main gate line structure soldered by the solder strips no longer appears on the front surface of the solar cell piece. As a consequence of this solution, the light is no longer blocked by these solder strips, thus greatly improving the light-receiving area and the power-generating efficiency of the solar cell piece. Meanwhile, the solar cell piece formed by electrically bonding a plurality of cell piece units 1 can effectively reduce the current of the short-circuit and the loss of fill factors, which significantly enhances the output efficiency of the solar cell piece. Furthermore, a cell string can be directly formed when the quantity of the cell piece units 1 that are electrically bonded together is sufficient (e.g., 20 pcs or more). It's unnecessary to solder the cell piece units 1 via the solder strips, greatly improving the production efficiency. Moreover, the hidden defects (e.g., insufficient soldering or weak soldering) caused by the traditional soldering process of the cell string can be overcome, greatly enhancing the quality of the cell pieces and the entire cell string.

In another aspect of the present invention, the two ends of the front main gate line, which exist along the direction of the main gate line, are disposed close to the edge of the outermost portion of the solar cell piece.

After adopting the above technical solution, short-circuit caused by the soldering paste can be prevented from happening between the positive and negative electrodes during the soldering process, especially on a mono-crystalline solar cell. When designing the main gate lines of a mono-crystalline solar cell, the length of the main gate line is slightly shorter than that of the short edge of the solar cell piece because the mono-crystalline solar cell has a larger corner chamfer. Such a design aims to prevent short-circuit from happening between the positive and negative electrodes when soldering small solar cell pieces having a corner chamfer into a cell string. Meanwhile, the material cost of printing the main gate lines can be saved.

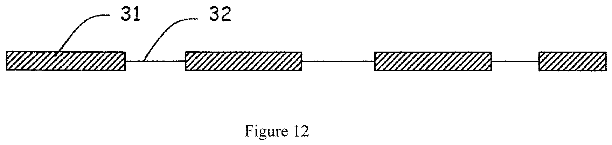

To further optimize the effect of the present invention, as shown in Figure 12, the front main gate line is composed of at least two separated soldering portion gate lines 31 and at least one connecting portion gate line 32. The width of the soldering portion gate line 31 is greater than that of the connecting portion gate line 32. The soldering portions are connected through the connecting portions.

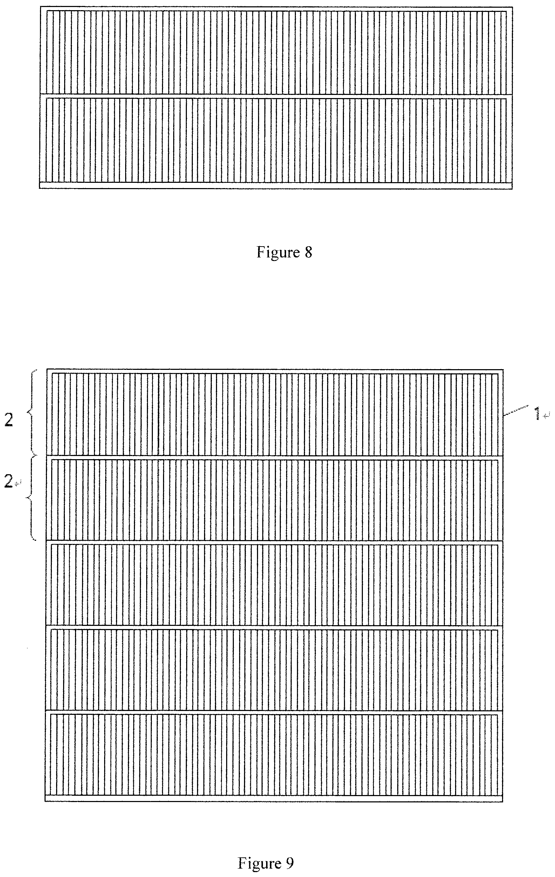

On basis of the above technical solution, the present invention can be further optimized as the following:
As shown in Figures 4 and 9, in some other embodiments of the solar cell piece of the present invention, the front main gate line 3 is connected to one end of the thin gate line 4.

The aforesaid technical solution allows the thin gate lines 4 to converge at one end, thereby allowing various cell piece units 1 to be conveniently bonded.

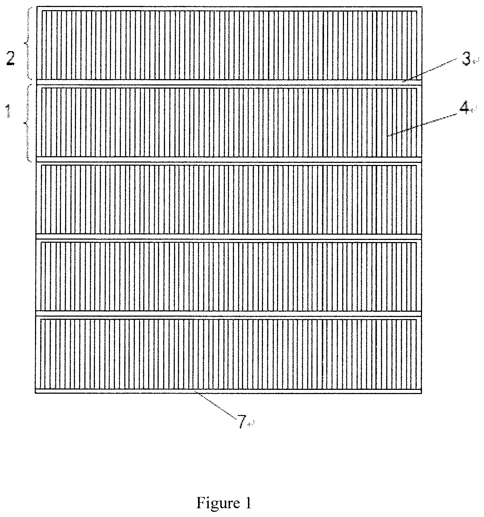

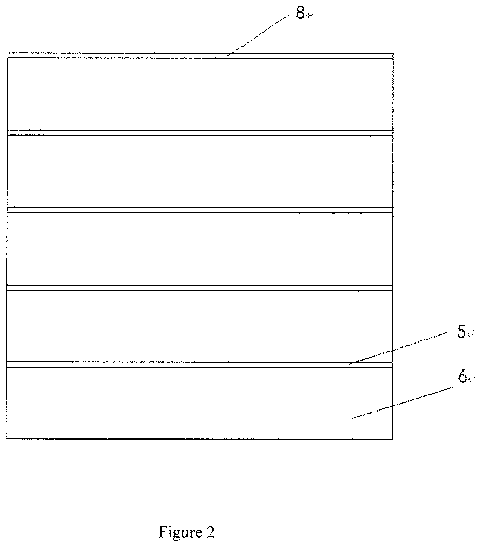

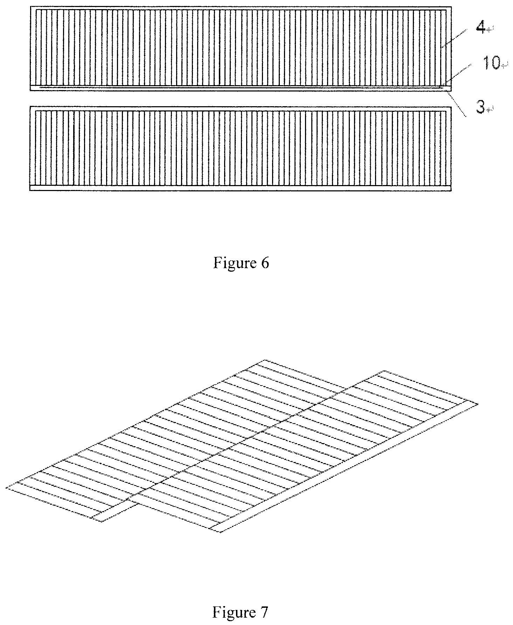

To achieve the purpose of the present invention, in some other embodiments of preparing the above solar cell piece of the present invention, namely the cell piece consisting of five cell piece units 1, comprising the following steps of:
Step 1: printing: as shown in Figures 1 and 2, printing the corresponding front screen-printed pattern and the back screen-printed pattern on the front surface and the back surface of the silicon chip layer, wherein the front screen-printed pattern comprises thin gate lines 4 and front main gate lines 3 that are perpendicular to the thin gate lines 4, an edge of one side of the front screen-printed pattern being provided with the front edge main gate line 7;
The back screen-printed pattern comprises back main gate lines 5 and an aluminum back surface field 6; the back main gate lines 5 and the front main gate lines 3 are disposed in the same direction; an edge of one side of the back screen-printed pattern is provided with the back edge main gate line 8; the front edge main gate lines 7 and the back edge main gate lines 8 are respectively disposed on two opposing sides of the silicon chip layer;
Step 2: cutting: as shown in Figure 3, cutting the silicon chip layer through a cutting apparatus along a cutting line 9, thereby forming a plurality of the cell piece units 1, wherein as shown in Figures 4 and 5, the cutting line 9 is overlapped with the edge of the front main gate line 3, and the cutting apparatus is a laser cutting apparatus or other cutting apparatuses;
Step 3: bonding: as shown in Figures 6 and 7, applying an electrically conductive bonding material 10 on the front main gate line 3 of the first cell piece unit 1, and bonding the back main gate line 5 of the second cell piece unit 1 to the front main gate line 3 of the first cell piece unit 1, thereby allowing the two cell piece units to be bonded together as shown in Figure 8; subsequently, bonding the third cell piece unit to the second cell piece unit in the same way; repeating the above step until the five cell piece units 1 are electrically bonded together, thereby completing the preparation of the solar cell piece as shown in Figure 9.

After adopting the above technical solution, the present invention has the following advantages:
The screen-printed patterns of a plurality of solar cell piece units 1 is printed on the silicon chip layer first. Subsequently, the silicon chip layer is cut into a plurality of solar cell piece units 1. Finally, these solar cell piece units 1 are electrically bonded together. Such a process can greatly improve the production efficiency. As a consequence, the light-receiving area of the solar cell pieces prepared by this method can be significantly increased, thereby enhancing the power-generating efficiency of the solar cell pieces.

On basis of the above technical solution, the present invention can be further optimized as the following:
To further optimize the implementation effect of the present invention, as shown in Figure 6, in some other embodiments of the solar cell piece of the present invention, the conductive bonding material 10 used in step 3 can be an electrical conductive adhesive, a soldering paste, an electrical conductive tape, or a solder strip. During the bonding process, the solar cell piece units are bonded via infrared bonding equipment, wave-soldering equipment or reflow-soldering equipment.

According to the above technical solution, various cell piece units are electrically bonded through the electrical conductive adhesive, soldering paste, electrical conductive tape, or solder strip, which can ensure the connection force and electrical conductivity between two cell piece units.

To further optimize the implementation effect of the present invention, as shown in Figure 3, in some other embodiments of the solar cell piece of the present invention, the cutting lines 9 in step 2 are all disposed on a same side with the front gate lines 3, and are consistent with the outer edge of the front edge main gate lines 7. The cutting lines 9 are all disposed at the lower edge of the front main gate lines 3, and are consistent with the outer edge of the front edge main gate lines 7.

After adopting the above technical solution, the solar cell piece can be rapidly cut, greatly improving the cutting efficiency. Meanwhile, waste products that are produced during the cutting process can be reduced, effectively improving the utilization rate of the raw materials.

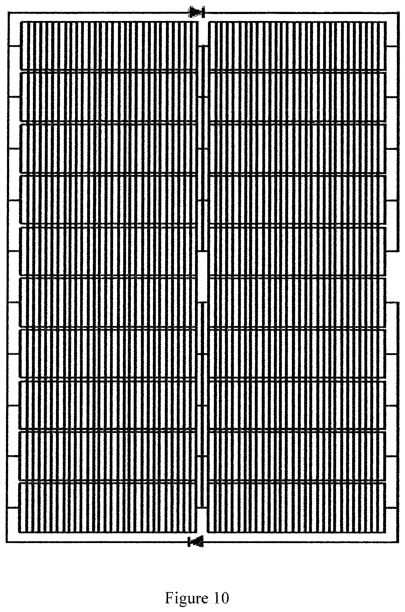

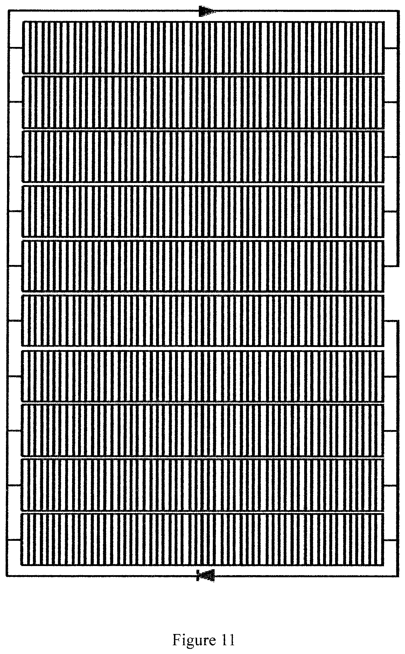

A cell string can be formed directly by electrically bonding a plurality of the cell piece units when the quantity of the cell piece units are sufficient to prepare a cell string. The type of the cell string can be various, thereby allowing different cell strings to be connected in series or in parallel to form different solar cell modules as shown in Figures 10 and 11. Such solar cell modules can correspond to various electric output parameters, which have a higher applicability.

In some embodiments, the back surface of the solar cell piece corresponds to the front surface area. A back main gate line is disposed at an edge of one side or a position close to the edge opposite to the main gate line that is disposed in the corresponding area of the front surface of the solar cell piece. The back main gate line is electrically connected to the back electrodes in the corresponding area of the solar cell piece. Such a design is convenient to connect the back electrodes. Whether or not all areas are connected after being cut, or connected through connecting wires without being cut, this specialized back main gate lines are more convenient for the soldering process, which can effectively avoid the bad connection.

In another aspect of the present invention, in some embodiments, an isolation zone, which enables the adjacent areas to be electrically isolated, is provided between adjacent areas on the front surface of the solar cell piece. It not only can electrically isolate all the areas, but can allow the areas to be conveniently cut along the isolation line when necessary.

In another aspect of the present invention, a portion of the back surface of the solar cell piece, which corresponds to the positon of the isolation zone on the front surface, is not provided with aluminum back field coating. Such a design can electrically isolate the back electrodes of all the areas, achieving a complete isolation between them. In a non-cutting application, all the areas can be conveniently connected in series or in parallel. Furthermore, the isolation line is not provided with the aluminum back field coating, effectively preventing metal burrs from happening during the cutting process. Consequently, the grinding time can be saved, and the production efficiency can be improved.

In another aspect of the present invention, a portion of the back surface of the solar cell piece, which corresponds to the position between the front surface areas, is provided with line-shaped or strip-like separating lines having no aluminum back field coating. After printing the separating lines, the solar cell piece can be easily cut, which can reduce the waste products produced during the cutting process.

In another aspect of the present invention, the front main gate lines of the two outermost areas of the front surface of the solar cell piece are disposed at an edge or a position close to the edge of the outermost portion of the solar cell piece. Being determined by the preparing process of the solar cell piece, the four corners of the solar cell piece can be arced or linear chamfered. After being cut into a plurality of areas, the cell piece units formed by the areas of the two ends of the solar cell piece can have two chamfers, and the cell piece units in the middle area are rectangle-shaped. When the edge of the chamfered cell piece unit is provided with a back main gate line, the chamfered part of a cell piece unit is overlapped with the upper surface of another cell piece unit once the two cell piece units are series-connected in an overlapped manner. As a result, the chamfered part of the cell piece unit is exteriorly exposed, resulting in an unpleasant appearance from the front surface of the solar cell module. After adopting the technical solution of the present invention, the edge having the chamfer can always be covered by one side of another cell piece unit having a right angle. Thus, the appearance of the whole solar cell module can be good-looking, beautiful and consistent.

In another aspect of the present invention, the front main gate line comprises a soldering portion and a connecting portion. The width of the soldering portion is greater than that of the connecting portion. The soldering portions are connected through the connecting portions. The front main gate line is either a single through-line, or a plurality of separated gate lines. Thus, the width of the front main gate lines can be various, effectively saving the cost.

In another aspect of the present invention, transverse thin gate lines, which connect the adjacent thin gate lines, and are perpendicular to the thin gate lines, are disposed between the thin gate lines. Such a configuration can allow the current of each power unit that is being collected by the adjacent thin gate lines to flow through the transverse thin gate line when one of the thin gate lines is broken.

A method for preparing the electrodes of a solar cell piece, comprising the steps of:
Step 1: printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel, and the main gate lines of the two edge areas of the solar cell piece being respectively disposed at the edge or close to the edge of the solar cell piece;
Step 2: printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.

The electrodes of the solar cell piece in above embodiments can be prepared by the method of the present invention. The solar cell piece prepared according to the method of the present invention can be cut into a plurality of cell piece units, or the front main gate lines and back electrodes of all the areas can be connected first through the connecting wires or by other means. Subsequently, the solar cell pieces can be connected to form the solar cell module of the present invention.

The description of above embodiments allows those skilled in the art to realize or use the present invention. Without departing from the spirit and essence of the present invention, those skilled in the art can combine, change or modify correspondingly according to the present invention. Therefore, the protective range of the present invention should not be limited to the embodiments above but conform to the widest protective range which is consistent with the principles and innovative characteristics of the present invention. Although some special terms are used in the description of the present invention, the scope of the invention should not necessarily be limited by this description. The scope of the present invention is defined by the claims.

## Claims

1. A solar cell piece, comprising:
an aluminum back field coating,
a silicon chip layer, and
thin gate lines, wherein a front surface of the solar cell piece is partitioned into at least two independent areas, at least one front main gate line being disposed at an edge of one side of each area or a position close to the edge, all the thin gate lines on the front surface of this area being electrically connected to the front main gate lines of this area.

2. The solar cell piece of claim 1, wherein the back surface of the solar cell piece corresponds to the front surface area, wherein a back main gate line is disposed at an edge of one side or a position close to the edge opposite to the main gate line that is disposed in the corresponding area of the front surface of the solar cell piece, wherein the back main gate line is electrically connected to the back electrodes in the corresponding area of the solar cell piece.

3. The solar cell piece of claim 1 or 2, wherein an isolation zone, which enables the adjacent areas to be electrically isolated, is provided between adjacent areas on the front surface of the solar cell piece.

4. The solar cell piece of claim 3, wherein a portion of the back surface of the solar cell piece, which corresponds to the positon of the isolation zone of the front surface, is not provided with the aluminum back field coating.

5. The solar cell piece of claim 3, wherein a portion of the back surface of the solar cell piece, which corresponds to the position between the front surface areas, is provided with line-shaped or strip-like separating lines having no aluminum back field coating.

6. The solar cell piece of claim 1 or 2, wherein the front main gate lines of the two outermost areas on the front surface of the solar cell piece are disposed at an edge or a position close to the edge of the outermost portion of the solar cell piece.

7. The solar cell piece of claim 1 or 2, wherein the two ends of the front main gate line, which exist along the direction of the main gate line, are disposed close to the edge of the outermost portion of the solar cell piece.

8. The solar cell piece of claim 1 or 2, wherein the front main gate line is a single through-line.

9. The solar cell piece of claim 1 or 2, wherein the front main gate line is composed of at least two separated soldering portion gate lines and at least one connecting portion gate line, wherein the width of the soldering portion gate line is greater than that of the connecting portion gate line, wherein the soldering portions are connected through the connecting portions.

10. The solar cell piece of claim 1 or 2, wherein transverse thin gate lines, which connect the adjacent thin gate lines, and are perpendicular to the thin gate lines, are disposed between the thin gate lines.

11. A method for preparing the electrodes of the solar cell piece of claim 1 or 2, comprising the steps of:
Step 1: printing the front electrodes: printing the corresponding front screen-printed pattern on the front surface of the silicon chip layer, wherein the front screen-printed pattern separates the solar cell piece into at least two areas, and each area comprises the thin gate lines and the front main gate line that is connected to the thin gate lines, the front main gate lines in different areas being arranged in parallel, and the main gate lines of the two edge areas of the solar cell piece being respectively disposed at the edge or close to the edge of the solar cell piece;
Step 2: printing the aluminum back surface field: printing the corresponding back screen-printed pattern on the back surface of the silicon chip layer, wherein the back screen-printed pattern comprises the back main gate lines and the aluminum back surface field, the back main gate line and the front main gate line being arranged in parallel, each area corresponding to the front surface being provided with a back main gate line, the back main gate line in each area being disposed on one side far from the front main gate line.

12. A solar cell module, comprising:
at least two cell piece units that are electrically bonded together, wherein the cell piece unit comprises a front surface and a back surface, wherein the front surface of the cell piece unit is provided with a power-generating area and a front main gate line that is disposed at an edge of one side of the power-generating area, wherein the power-generating area is provided with a plurality of thin gate lines, and the thin gate lines are connected to the front main gate line, wherein the back surface of the cell piece unit is provided with a back main gate line and an aluminum back surface field, wherein the front main gate line and the back main front line are respectively disposed on two opposite sides of the cell piece unit, wherein the back main gate line of one cell piece unit is bonded to and electrically connected to the front main gate line of another cell piece unit.

13. The solar cell module of claim 10, wherein the front main gate line is connected to one end of the thin gate line.

14. A method for preparing the cell piece unit of claim 10 or 11, comprising the steps of:
Step 1: printing: printing the corresponding front screen-printed pattern and back screen-printed pattern on the front surface and the back surface of the silicon chip layer, wherein the front screen-printed pattern comprises thin gate lines and front main gate lines that are perpendicular to the thin gate lines, an edge of one side of the front screen-printed pattern being provided with the front edge main gate line;
The back screen-printed pattern comprises back main gate lines and an aluminum back surface field; the back main gate lines and the front main gate line are disposed in the same direction; an edge of one side of the back screen-printed pattern is provided with the back edge main gate line; the front edge main gate lines and the back edge main gate lines are respectively disposed on two opposite sides of the silicon chip layer;
Step 2: cutting: cutting the silicon chip layer through a cutting apparatus along a cutting line, thereby forming a plurality of the cell piece units, wherein the cutting line is used to cut the silicon chip layer into independent cell piece units;
Step 3: bonding: applying an electrically conductive bonding material on the front main gate line of the first cell piece unit, and bonding the back main gate line of the second cell piece unit to the front main gate line of the first cell piece unit, thereby allowing the two cell piece units to be bonded together; subsequently, bonding the third cell piece unit to the second cell piece unit in the same way; repeating the above step until all the cell piece units are electrically bonded together, thereby completing the preparation of the solar cell piece.

15. The method for preparing the cell piece unit of claim 12, wherein the conductive bonding material used in step 3 can be an electrically conductive adhesive, a soldering paste, an electrically conductive tape, or a solder strip.
